# EUROPÄISCHE PATENTSCHRIFT

(11) **EP 1 277 801 B1**
(45) Veröffentlichungstag und Bekanntmachung des Hinweises auf die Patenterteilung: **16.07.2008**
(21) Anmeldenummer: 02010042.6
(22) Anmeldetag: 06.05.2002
(51) Int. Cl.: C08L 75/04, C08K 5/01, A43B 13/38

(54) **Werkstoff aus einem Polyurethan-Gel, Herstellungsverfahren und Verwendungen**
Material made a from polyurethane gel, method of preparation and uses
Matériau à base de gel de polyuréthanne, procédé de préparation et utilisations

(30) Priorität: 19.07.2001 US 306644 P
(43) Veröffentlichungstag der Anmeldung: 22.01.2003
(73) Patentinhaber: Otto Bock HealthCare GmbH, 37115 Duderstadt (DE)
(72) Erfinder: Pause, Barbara Dr., Longmont, CO 80503 (US); Stender, Adolf, 37115 Duderstadt (DE); Gansen, Peter Dr., 37136 Seeburg (DE)
(74) Vertreter: Läufer, Martina

(56) Entgegenhaltungen:
- EP-A- 0 057 839
- WO-A-02/34809
- DE-A- 2 347 299
- DE-A- 2 652 255
- US-A- 4 102 716
- US-A- 5 713 143
- US-A- 5 939 157
- Datenblatt Shea Butter Internet
- Google: pcm phase change
- Internet: Funktionelle Skikleidung durch Ausnutzung der Übergangswärmen
- Internet: Phase Change Material
- Kunststofflexikon, 1992, S. 656,657: Weichmachung

## Beschreibung

Die Erfindung betrifft einen Werkstoff aus einem Polyurethan-Gel mit darin enthaltenen fein verteilten Phasenübergangsmaterialien, sog. "Phase Change Materialien" (PCM), ein Verfahren zur Herstellung derartiger Werkstoffe und zugehörige Verwendungen.

Die Einbringung von Materialien, die bei einem Phasenwechsel vom festen in den flüssigen Aggregatszustand große Wärmemengen aus der Umgebung aufnehmen und speichern, in solche, die den Aggregatszustand im gleichen Temperaturbereich nicht wechseln, führt zu einem Klimatisierungseffekt, der u.a. bei funktionellen Textilien (im Sport- und Freizeitbereich) gewünscht wird.

Die ein- oder aufgebrachten Phasenübergangsmaterialien, sogenannte "Phase Change Materials" (PCM), besitzen die Fähigkeit ihren Aggregatszustand innerhalb eines bestimmten (gewünschten und einstellbaren)Temperaturbereichszu ändern. Bei Erreichen der Schmelztemperatur während eines Erwärmungsvorgangs tritt ein Phasenübergang vom festen in den flüssigen Zustand ein. Während dieses Schmelzprozesses absorbiert und speichert das PCM eine große latente Wärme. Die Temperatur des PCMs bleibt während des gesamten Vorgangs nahezu konstant.

Während eines anschließenden Abkühlvorgangs wird die gespeicherte Wärme aus dem PCM wieder an die Umgebung abgegeben und der umgekehrte Phasenübergang vom flüssigen zum festen Zustand findet statt. Auch während dieses Kristallisationsvorgangs bleibt die Temperatur des PCMs konstant.

Vor ihrer Anwendung in funktionellen Textilien wird das PCM mikroverkapselt, um das Auslaufen des geschmolzenen PCMs in die Textilstruktur zu verhindern.

Zum besseren Verständnis wird der Betrag latenter Wärme, der von einem PCM während des Phasenübergangs absorbiert wird, mit der spezifischen Wärme in einem gewöhnlichen Erwärmungsprozess verglichen. Zum Vergleich wird der Eis-Wasser-Übergang herangezogen. Wenn Eis schmilzt, absorbiert es eine latente Wärme von etwa 335 J/g. Wenn das Waser weiter erwärmt wird, absorbiert es während einer Temperaturerhöhung von 1 °C eine spezifische Wärme von nur 4 J/g. Die Absorption latenter Wärme während des Phasenübergangs von Eis zu Wasser ist daher nahezu 100mal größer als die Absorption spezifischer Wärme während des normalen Erwärmungsvorgangs ausßerhalb des Phasenübergangsbereichs.

Außer dem System Eis/Wasser sind mehr als 500 natürliche und synthetische PCMs bekannt. Diese Materialien unterscheiden sich durch ihre Phasenübergangstemperaturen und ihre Wärmeaufnahmekapazitäten.

Derzeit werden für die Ausrüstung von Garnen und Textilien ausschließlich kristalline Kohlenwasserstoff-PCMs mit unterschiedlicher Kettenlänge verwendet. Die Charakteristiken dieser PCMs sind in der folgenden Tabelle 1 zusammengefasst:

| Phase Change Material | Melting Temp. [°C] | Kristallisationstemp. [°C] | Wärmespeicherkapazität [J/g] |
|---|---|---|---|
| Heneicosan | 40,5 | 35,9 | 213 |
| Eicosan | 36,1 | 30,6 | 247 |
| Nonadekan | 32,1 | 26,4 | 222 |
| Octadekan | 28,2 | 25,4 | 244 |

Die kristallinen Alkane werden entweder in technischer Reinheit von ca. 95 % oder in Mischungen, die bestimmte Phasenübergangstemperaturbereiche abdecken sollen, verwendet. Die kristallinen Alkane sind nicht toxisch, nicht korrosiv und nicht hygroskopisch. Das thermische Verhalten dieser PCMs bleibt auch bei andauerndem Gebrauch stabil. Kristalline Alkane sind Nebenprodukte aus der Ölraffinerie und daher billig. Sie sind rein, wie auch in nach dem Schmelzbereich definierten Mischungen erhältlich.

Als PCMs werden in der Textilindustrie derzeit ausschließlich mikroverkapselte kristalline Alkane verwendet, die in kleinen Mikrokapseln mit Durchmessern von ca. 1 bis 30 Mikrons eingeschlossen sind. Diese mikroverkapselten PCMs werden auf die Textilien aufgebracht, indem sie in Acrylfasern oder auch Polyurethanschäume eingebracht und als Beschichtung auf die Fasern aufgebracht werden.

US-PS 4 756 958 beschreibt eine Faser mit integrierten Mikrokapseln, die mit PCM gefüllt sind. Die Faser besitzt verbesserte thermische Eigenschaften in einem vorbestimmten Temperaturbereich.

US-PS 5 366 801 beschreibt eine Beschichtung aus PCM-gefüllten Mikrokapseln für Textilien, um diese mit verbesserten thermischen Eigenschaften auszustatten.

US-PS 5 637 389 beschreibt einen in seinem thermischen Verhalten verbesserten lsolationsschaum, bei dem die PCM-Mikrokpseln in den Schaum eingebettet sind.

Mikroverkapselungsverfahren sind sehr zeitaufwendige und komplizierte, mehrstufige Verfahren. Mikroverkapselte PCMs sind daher sehr teuer.

Außer für dünne Beschichtungen ist bei Kunststoffen (Polymeren) die Zugabe von mikroverkapselten PCMs nicht üblich, da der Wärmeübergang im Innern beispielsweise von Formkörpern sehr schlecht wäre.

Es sind Polyurethan-Gele bekannt, die sich u.a. durch eine hohe Verformbarkeit auszeichnen und beispielsweise für Sitzkissen und Polster verwendet werden. Diese Polyurethangele führen jedoch bei Körperkontakt häufig zu einem unangenehmen Kältegefühl und allgemein einer schlechten Klimatisierung.

Die EP-A-057839 offenbart entsprechende Polyurethangele, bei denen Wirkstoffe in der Polyolkomponente und dadurch anschließend in dem Gel dispergiert sein können.

Die WO 02/34809 A offenbart ein Polyurethan-Gel als Wärme-Isolationsmaterial für Leitungen zum Materialtransport, das mit einem chemisch inerten organischen flüssigen Material beladen bzw. gestreckt oder expandiert ist.

Die US-A-4102716 beschreibt ein Polyurethangel, das mit einem aliphatischen oder naphtenischen Kohlenwasserstofföl gestreckt bzw. expandiert ist. Offenbart wird dort ein auch bei kalten Temperaturen gießbares dielektrisches Füllmaterial zum Eingießen elektronischer Komponenten für Kabelendisolierungen und Umhüllungen. Das enthaltene aliphatische oder naphtenische Öl wird als im gesamten Anwendungsbereich flüssiges Gleitmittel verwendet.
Die DE 26 52 255 A betrifft ebenfalls mit Mineralöl gestreckte Polyurethansysteme, allerdings keine Gele.

Die US-A-5939157 beschreibt die Verwendung flüssiger auch paraffinischer Weichmacher in Polyurethangelen, während bei der US-A-5713143 einem Polyurethangel innerhalb einer orthopädischen Schuheinlage anstelle eines Weichmachers ein pflanzliches Fett oder Öl zugegeben wird.

Die DE 23 47 299 offenbart ein Hydrogel mit ca. 95 %igem Wasseranteil. Hierbei wird das Wasser in die gelartige Masse mit Hilfe des Polyurethannetzwerkes eingebunden.

Die Aufgabe der Erfindung besteht darin, das thermische Verhalten von PolyurethanGelen im Sinne eines temperaturausgleichenden Verhaltens zu verbessern.

Zur Lösung dieser Aufgabe sieht die Erfindung bei einem Werkstoff aus einem Polyurethan-Gel, bei dem das Produkt der Funktionalitäten der Polyurethanbildenden Komponenten wenigstens 5,2 beträgt und der durch Emulgieren oder Dispergieren fein verteilte Materialien enthält vor, dass die fein verteilten Materialien "Phase-Change-Materialien" deren Schmelzpunkte oder Schmelzbereiche zwischen 20 °C und 45°C liegen, nämlich Paraffine sind, und dass der Werkstoff dadurch ein temperaturausgleichendes Verhalten zeigt.

Überraschenderweise wurde gefunden, dass die Phase Change Materialien nicht verkapselt sein müssen und dennoch nicht ausdiffundieren oder agglomerieren. Feinverteilte, in dem Polyurethan-Gel emulgierte oder dispergierte PCMs bleiben über lange Gebrauchszeiten unverändert stabil.

Die für Polyurethan-Gele verwerdeten Polyurethane sind kovalent vernetzte Polyurethanmatrices mit hohen Molekulargewichten. Die Gelstruktur kommt durch geeignete Wahl der Funktionalitäten und Molekulargewichte der Ausgangskomponenten zustande. Die verwendeten Polyurethan-Gele können in der Polyurethanchemie übliche Zusatzstoffe und Additive enthalten.

Bevorzugt werden die für die Erfindung verwendeten Gelmassen mit Rohstoffen hergestellt, bei denen das Produkt der Funktionalitäten der Polyurethan-bildenden Komponenten mindestens 6,5 und insbesondere mindestens 7,5 beträgt.

Die Polyolkomponente zur Herstellung des Gels kann aus einem oder mehreren Polyolen mit einem Molekulargewicht zwischen 1 000 und 12 000 und einer OH-Zahl zwischen 20 und 112 bestehen, wobei das Produkt der Funktionalitäten der polyurethanbildenden Komponenten mindestens 5,2 beträgt, wie oben angegeben, und die Isocyanat-Kennzahl zwischen 15 und 60 liegt.

Als Isocyanate werden zur Gelherstellung bevorzugt solche der Formel Q(NCO)n verwendet, wobei n für 2 bis 4 steht und Q ein aliphatischer Kohlenwasserstoffrest mit 8 bis 18 C-Atomen, ein cycloaliphatischer Kohlenwasserstoffrest mit 4 bis 15 C-Atomen, ein aromatischer Kohlenwasserstoffrest mit 6 bis 15 C-Atomen oder ein araliphatischer Kohlenwasserstoffrest mit 8 bis 15 C-Atomen ist. Dabei können die Isocyanate in reiner Form oder in einer üblichen Isocyanat-Modifizierung wie z.B. Urethanisierung, Allphanatisierung oder Biuretisierung eingesetzt werden, wie dies dem Fachmann bekannt ist.

Als Phasenübergangsmaterialien oder Phase Change Materialien (PCMs) können grundsätzlich alle Paraffine verwendet werden deren Phasenübergang in dem gewünschten Temperaturbereich liegt und die sich bei der Gelherstellung mit einbinden lassen. Bevorzugt werden kristalline Alkane verwendet.

Die Schmelzpunkte oder Schmelzbereiche der verwendeten PCMs liegen bevorzugt zwischen 34 und 39 °C. Bei Anwendungen, bei denen der Werkstoff körpemah für einen Ausgleich der Körpertemperatur sorgen soll, ist ein Phasenübergangsbereich bei mittlerer menschlicher Körpertemperatur ideal, um Überhitzungen - etwa beim Sport - sofort abfangen zu können.

Bevorzugt werden die PCMs in einem Gewichtsanteil von bis zu 60 Gew.-%, weiter vorzugsweise bis zu 40 Gew.-%, bezogen auf das Gesamtgewicht in den Werkstoff eingearbeitet.

Zusätzlich können in dem Werkstoff Füllstoffe enthalten sein. Der Fachmann kann die Füllstoffe und die verwendbaren Mengen dieser Füllstoffe im Rahmen dessen auswählen, was in der Polymerchemie und insbesondere in der Polyurethanchemie hierzu allgemein bekannt ist. Als Füllstoffe können insbesondere auch elastische Mikrohohlkugeln vorgesehen sein, deren Hüllen vorzugsweise aus polymerem Material, insbesondere Polyolefin bestehen. Die elastischen Mikrohohlkugeln können, wenn dies zusätzlich gewünscht wird, expandiert oder unter Verarbeitungsbedingungn expandierbar sein. Mikrohohlkugeln sind gasgefüllte (luftgefüllte) Mikroballons, wobei es hier auf die Kugelform nicht ankommt. Häufig wird auch von "mikrozelligem Material" bzw. von Mikrozellen gesprochen. Die Mikrohohlkugeln verringern das spezifische Gewicht und nehmen Einfluss auf die mechanischen Eigenschaften des Werkstoffs. Es werden bis zu 20, vorzugsweise bis zu 10 Gew.% Mikrozellen eingesetzt. Geeignete Mikrohohlkugeln, wie auch andere Füllstoffe, sind kommerziell erhältlich.

Der Werkstoff kann unter anderem für die Herstellung von Schuhinnensohlen, Schuhauskleidungen, Matratzen, Sitzauflagen und ganzen Sitzkissen verwendet werden. Dabei können in den Werkstoff weitere Zusätze oder Füllstoffe eingearbeitet sein, wie im Stand der Technik bekannt. Schuheinlegsohlen können bevorzugt wenigstens bereichsweise aus dem neuen Werkstoff bestehen, beispielsweise im Bereich der Fußdruckpunkte.

Sohlen, Matratzen, Sitzauflagen und Kissen können mit einer textilen Abdeckung versehen sein. Der erfindungsgemäße Werkstoff kann direkt auf textile Materialien laminiert werden.

Die Erfindung umfasst auch ein Verfahren zur Herstellung des neuen Werkstoffs. Als Polyurethankomponenten werden bevorzugt die oben schon genannten verwendet. Geeignete Zusammensetzungen für Polyurethan-Gele sind beispielsweise beschrieben in EP 057 838 und auch EP 0 511 570. Die PCMs werden zu den Ausgangskomponenten oder spätestens bei der Gelbildung zugegeben. Hierdurch werden sie in die sich bildende feste Polyurethanstruktur dauerhaft mit eingebunden.

Der erfindungsgemäße Werkstoff kann besonders vorteilhaft hergestellt werden, indem das Phase Change Material in einer flüssiger PU-Komponente emulgiert oder dispergiert wird, und die PU-Komponenten danach zu dem Polyurethan-Gel umgesetzt werden. Alternativ kann das PCM auch in die fertige Polyurethanmischung vor Gelbildung eingebracht werden. Welche Verfahrensweie gewählt wird, hängt auch von dem gewünschten Verteilungsprofil ab. Der Fachmann kann anhand von Versuchen die jeweils beste Möglichkeit zur Einarbeitung des PCMs ermitteln.

In besonders bevorzugter Ausführungsform wird das Phase Change Material, und zwar vorzugsweise ein Alkan in flüssigem Aggregatszustand (geschmolzen) eingesetzt. Das flüssige PCM wird zunächst unter Bildung einer flüssig/flüssig-Emulsion in die Polyolkomponente eingearbeitet, die dann wie üblich weiterverarbeitet wird. Der Grad der Feinverteilung des PCMs in der Emulsion richtet sich u.a. nach Intensität und Dauer, mit der gemischt, d.h. im allgemeinen gerührt wird. Außerdem beeinflussen geeignete Additive wie Stabilisatoren und Emulgatoren den Grad der Feinverteilung. Der Fachmann kann dies in gewissen Grenzen einstellen und hierdurch die Verteilung des PCMs im späteren Werkstoff beeinflussen.

Die Emulsion kann vorzugsweise durch den Zusatz eines Emulsions-Stabilisators stabilisiert werden. Hierfür können beispielsweise Aerosile verwendet werden.

In alternativer Ausführungsform kann das flüssige Phase Change Material mit allen Komponenten des späteren Gel-Werkstoffs gemischt und intensiv gerührt werden bis die Gelbildung einsetzt. Mit beginnender Gelbildung wird die Masse dann im allgemeinen in die durch die gewünschten Produkte vorgegebenen Formen gegossen.

In anderen Ausführungsformen könnten feste, pulverförmige PCMs in das Gel eingearbeitet bzw. in der Polyolkomponente dispergiert werden. Die Verarbeitung geschieht ansonsten in üblicher Weise.

Polyurethan-Gele besitzen zahlreiche vorteilhafte Eigenschaften, die bereits im Stand der Technik für viele Produkte genutzt werden. Diese bekannten Eigenschaften, wie gutes Druckverteilungsvermögen, hohe Schock- und Scherkraftabsorption, hohe Elastizität und gute Rückstellfähigkeit, bleiben auch bei dem neuen, Phase Change Materialien umfassenden Werstoff erhalten. Zu den Eigenschaften bisher bekannter Polyurethan-Gele kommt nun in dem neuen Werkstoff ein gutes Klimatisierungs-Verhalten, d.h. ein gutes Wärmeregulationsverhalten, hinzu. Die für Polymere hohe Wärmeleitfähigkeit der PU-Gele von etwa 0,410 W/mK erlaubt einen sehr guten Wärmetransport zwischen PCMs und Umgebung.

Besondere Anwendungsmöglichkeiten für den neuen Werkstoff ergeben sich daher in Bereichen, wo überschüssige Wärme, beispielsweise vom Körper einer Person, abgepuffert werden soll. Durch das Material wird überschüssige Wärme durch die hohe Wärmekapazität des PCM beim Phasenübergang vorübergehend aufgenommen und später bei Körperabkühlung, also bei Bedarf, wieder abgegeben. Beispielsweise kann überschüssige Wärme, die vom Fuß beim Laufen erzeugt wird, durch eine Innensohle aus dem neuen Werkstoff zeitweise absorbiert werden.

Die Struktur des Polyurethan-Gelmaterials erlaubt eine hohe Beladung mit PCMs, für kristalline Alkane bis zu etwa 60 Gew.% bezogen auf das Gesamtgewicht des Werkstoffs, vorzugsweise bis 40 Gew.%. Zusätzlich kann das Polyurethan-Gel weitere Zusätze enthalten, insbesondere solche, die für Polyurethan-Gele bereits bekannt sind, beispielsweise Teilchen niedriger Dichte.

In einem Polyurethan-Gelmaterial mit einer Dicke von 1,5 mm und einem Gewicht von 1760 g/m² kann beispielsweise eine Wärmeaufnahmekapazität von etwa 140 kJ/m² erreicht werden, wenn kristalline Alkane mit einer latenten Wärmekapazität von etwa 200 J/g verwendet werden. Die Wärmespeicherkapazität kann auf etwa bis zu 250 kJ/m² erhöht werden, wenn das Alkan-PCM in einem Gelmaterial mit einem spezifischen Gewicht von 3150 g/m² verwendet wird. Die Wärmeaufnahmekapazität, die auf diese Weise erzielt werden kann, übertrifft bei weitem die Kapazität gängiger PU-Schäume mit mikroverkapselten PCMs, die bei 20 bis 40 kJ/m² liegt. Mit mikroverkapselten PCMs beschichtete Textilien besitzen latente Wärmeaufnahmekapazitäten von zwischen 5 kJ/m² und 15 kJ/m².

Im folgenden wird die Erfindung anhand von Beispielen für Einlegsohlen illustriert.

### BEISPIELE

### Einlegsohlen aus PCM-haltigem Polyurethan-Gel

Durch das PCM soll die überschüssige vom Fuß abgegebene Wärme absorbiert werden und damit der Temperaturanstieg auf der Haut merklich verzögert werden. Die Verzögerung des Temperaturanstiegs führt zu einer später einsetzenden und außerdem geringeren Schweißbildung, was eine wesentliche Verbesserung des thermophysiologischen Komforts zur Folge hat. Aus der Kombination der hervorragenden mechanischen Eigenschaften der Polyurethan-Gel-Materialien und der thermischen Wirkung der PCMs wird eine signifikante Verbesserung des Tragekomforts beim Einsatz der Einlegesohlen in den verschiedensten Schuhvarianten erreicht.

### 1. Ermittlung wärmephysikalischer Kenndaten

Die Untersuchungen wurden an folgenden Einlegesohlen durchgeführt (Beispiele C, D und E sind nicht erfindungsgemäße Vergleichsbeispiele):
A. PCM-haltige PU-Gelsohle mit 20 % Paraffin-PCM
B. PCM-haltige PU-Gelsohle mit 40 % Paraffin-PCM
C. PCM-haltige PU-Gelsohle mit 10 % mikroverkapseltem Paraffin-PCM (THS 95)
D. PCM-haltige PU-Gelsohle mit 20 % mikroverkapseltem Paraffin-PCM (THS 95)
E. PU-Gel-Einlegsohle ohne PCM
F: PU-Gel Einlegsohle mit 25 % Paraffin-PCM (CeraSer 318)
G: PU-Gel Einlegsohle mit 25 % Paraffin-PCM (CeraSer 318) und 2 % Mikrohohlku geln

Die Prozentangaben beziehen sich jeweils auf Gew.% bezogen auf das Gesamtgewicht des Werkstoffs.

Als Paraffin-PCM wurden kommerziell erhältliche Reinparaffine und Paraffingemische verwendet, die durch ihren Schmelzbereich bzw. Schmelzpunkt charakterisiert werden (eine im Handel erhältliche Paraffinmischung ist beispielsweise Cera Ser ®).

Mit Hilfe eines kalorimetrischen DSC-Messgeräts wurden die Temperaturbereiche latenter Wärmeaufnahme und -abgabe des in den Einlegesohlen enthaltenen Paraffin-PCMs ermittelt sowie dessen Wärmespeicherkapazität bestimmt.

Die Ergebnisse der DSC-Tests sind in Tabelle 1 zusammengefasst. Für die in den PU-Gel-Einlegesohlen enthaltenen Paraffin-PCMs wurden die Temperaturbereiche der latenten Wärmeaufnahme und der latenten Wärmeabgabe, die Schmelz- und Kristallisationstemperaturen (Peakwerte) sowie die latenten Wärmeaufnahmen und - abgaben in diesen Messungen ermittelt. Alle Ergebnisse sind Mittelwerte aus jeweils drei Tests.

**Tabelle 1:Messergebnisse der DSC-Tests**

| Prüfstoff | Temp. bereich Wämeaufn. | Schmelztemp. (Peak) | Latente Wärmeaufnahme | Temp.bereich Wärmeabgabe | Kristallisationstemp. (Peak) | Latente Wärmeabgabe |
|---|---|---|---|---|---|---|
| | in °C | in °C | in J/g | in °C | in °C | in J/g |
| A | 18-38 | 32,86 | 9,78 | 10-35 | 28,46 | 11,29 |
| B | 18-45 | 35,40 | 20,98 | 15-38 | 34,23 | 21,54 |
| C | 25-38 | 35,04 | 9,44 | 13-23 | 18,38 | 1,55 |
| | | | | 23-35 | 32,11 | 5,45 |
| D | 25-38 | 35,03 | 12,25 | 13-23 | 17,97 | 2,11 |
| | | | | 23-35 | 32,26 | 6,49 |

Zusätzlich wurde der Einfluss von Füllstoffen untersucht. Die Ergebnisse von DSC-Tests an je einer Einlegesohle mit und ohne Mikrozellen bzw. Mikrohohlkugeln im Gel, sowie einer Sohle ohne PCMs, sind in Tabelle 2 zusammengefasst. Alle Ergebnisse sind Mittelwerte aus jeweils drei Messungen.

**Tabelle 2:DSC an PCM-PU-Gel-Einlegsohlen mit und ohne Mikrohohlkugeln**

| Testmaterial | Temp. bereich Wämeaufn. | Schmelztemp. (Peak) | Latente Wärmeaufnahme | Temp.bereich Wärmeabgabe | Kristallisationstemp. (Peak) | Latente Wärmeabgabe |
|---|---|---|---|---|---|---|
| | in °C | in °C | in J/g | in °C | in °C | in J/g |
| PU-Gel 25 % Cera-Ser 318 ohne MB | 15-20 | 18,01 | 0,39 | 10-17 | 15,42 | 0,53 |
| | 20-40 | 35,27 | 19,56 | 17-36 | 31,29 | 21,78 |
| PU-Gel 25 % Cera-Ser 318 mit MB | 15-20 | 18,21 | 0,38 | 10-17 | 14,85 | 0,37 |
| | 25-43 | 35,56 | 17,40 | 17-37 | 32,36 | 18,11 |
| MB = Mikrozellen/Mikrohohlkugeln | | | | | | |

Die Messergebnisse aus Tabelle 2 zeigen, dass sich die latente Wärmekapazität der Einlegesohlen durch den Zusatz von etwa 2 % an luftgefüllten Mikrozellen (MB) um etwa 15 % verringert. Die Temperaturbereiche der latenten Wärmeaufnahme bzw.

Wärmeabgabe verschieben sich durch den Zusatz der luftgefüllten Mikrozellen etwas zu höheren Temperaturen.

Die verwendeten PU-Gel-Einlegesohlen besitzen unterschiedliche Größen und sind unter anderem demzufolge auch unterschiedlich schwer. Tabelle 3 enthält die Gewichte der in den Untersuchungen verwendeten Einlegesohlen. Unter Bezugnahme auf das Sohlengewicht wurde die latente Wärmespeicherkapazität der Einlegesohlen ermittelt. Der in Klammern angegebene Wert bezieht sich auf eine einheitliche Einlegesohlengröße, die der Schuhgröße 39/40 entspricht. Die Sohlengröße wurde in den Tragetests verwendet.

**Tabelle 3:Gewichte der Einlegesohlen und latente Wärmespeicherkapazität des in den Sohlen enthaltenen Paraffin-PCMs**

| Einlegesohle | Gewicht | Latente Wärmespeicherkapazität |
|---|---|---|
| | in g | in kJ |
| A | 68 | 0,7 |
| B | 69 | 1,5 |
| C | 84 | 0,6 (0,4) |
| D | 84 | 0,8 (0,7) |
| E | 50 | - |

### 2. Eigenschaftstests - Tragetests

Die Eigenschaften der verschiedenen Sohlen wurden durch Tragestests mit Versuchspersonen untersucht.
Die Tests bestanden aus einem 30-minütigen Lauf in einer Klimakammer auf dem Laufbandergometer mit einer Geschwindigkeit von etwa 8 km/h. Während der Tests betrug die Umgebungstemperatur 21 °C und die relative Luftfeuchte 40 %. Für die Tests wurde das jeweilige Sohlenmuster in einen normalen Sportschuh eingelegt. In den Tests wurden von den Probanden Baumwollsocken sowie normale Sportkleidung getragen.

Während der Tests wurde der Temperaturverlauf an insgesamt 4 Hautmessstellen (Große Zehe, Fußrücken, Knüchel und Fußbett) sowie an zwei Stellenauf der Oberfläche der Einlegesohle kontinuierlich unter Verwendung eines Loggersystems ermittelt. Aus den Temperaturmesswerten an den vier verschiedenen Hautmessstellen wurde die mittlere Hauttemperatur berechnet. Die Messergebnisse der beiden Sensoren, die auf der Oberfläche der Einlegesohle lokalisiert waren, wurden ebenfalls gemittelt. Außerdem wurde der Feuchteanstieg im Mikroklima bestimmt. Jedes Sohlenmuster wurde zweimal getestet und die erhaltenen Testergebnisse wurden gemittelt. Untersucht wurden:
1. Polyurethan-Gel-Einlegsohle ohne PCM;
2. Polyurethan-Gel-Einlegsohle mit 25 % mikroverkapseltem PCM;
3. Polyurethan-Gel-Einlegsohle mit 25 % reinem PCM;
4. Polyurethanschaum-Einlegsohle mit 50 % mikroverkapseltem PCM (%-Angaben jeweils in Gew.-%),
dabei sind die Beispiele 1, 2 und 4 Vergleichsbeispiele für das erfindungsgemäße Beispiel 3.

Die Untersuchungsergebnisse werden im Folgenden anhand von Abbildungen wiedergegeben:
Abb. 1: Temperaturentwicklung im Schuh-Mikroklima;
Abb. 2: Feuchtigkeitswentwicklung über 30 Minuten.

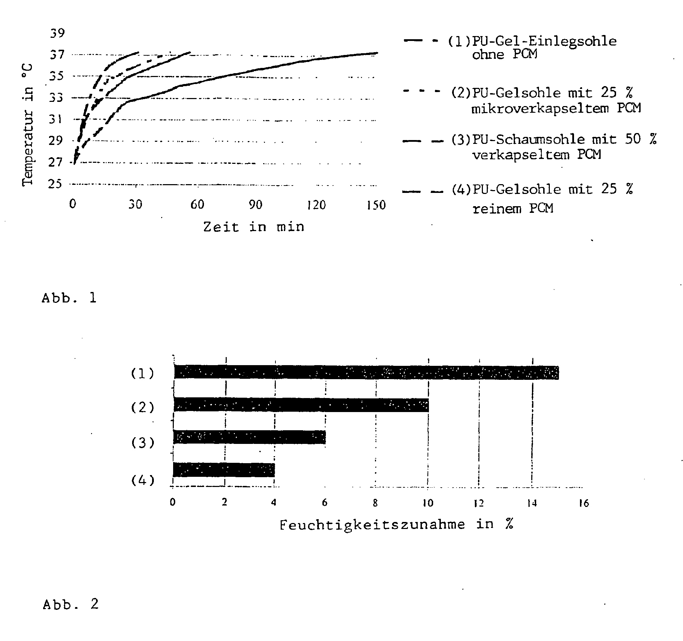

In dem 30-minütigen Lauftest wurden auf der Oberfläche der PU-Gel-Einlegesohlen die in Figur 1 dargestellten Temperaturen gemessen.

Die Testergebnisse zeigen, dass bei Verwendung einer Polyurethan-Gel-Einlegsohle ohne PCM bereits nach 30 Minuten eine Endtemperatur von ca. 37°C im Laufschuhmikroklima erreicht ist. Durch Zugabe von 25 % mikroverkapselter PCMs zu dieser Polyurethan-Gel-Einlegsohle wird diese Zeitspanne bereits um ca. 15 Minuten verlängert. Die Verwendung von 25 % reinem, unverkapseltern PCM verlängert jedoch die Zeitspanne bis zum Erreichen der Endtemperatur auf insgesamt 150 Minuten. Durch Verwendung unverkapselter PCMs in der Polyurethan-Gel-Innensohle wird daher ein wesentlicher und lange anhaltender Kühlungseffekt erreicht.

Der Grund für den nur kürzeren Kühleffekt der entsprechenden Sohle mit mikroverkapseltem PCM ergibt sich durch Verluste der latenten Wärmekapazität durch die Mikroverkapselung selbst und einen größeren Wärmeübergangswiderstand auf die Mikrokapseln. Trotz des wesentlich höheren PCM-Anteils wird bei der PU-Schaumsohle mit mikroverkapseltem PCM ein deutlich geringerer Kühlungseffekt erzielt, was auf den stark behinderten und verzögerten Wärmeübergang in dem Schaum und durch die Mikrokapseln verursacht wird.

Die Verzögerung des Temperaturanstiegs im Schuh-Mikroklima beim Laufen schlägt sich auch in einem verzögerten Feuchtigkeitsanstieg nieder. Die Testergebnisse für die Feuchtigkeitszunahme im Mikroklima des Schuhs beim Laufen über einen Zeitraum von 30 Minuten sind in Figur 2 zusammengefasst.

Figur 2 zeigt, dass die Wärmeabsorption durch das PCM zu einem wesentlich geringeren Feuchtigkeitsanstieg im Mikroklima des Schuhs führt. Dies führt insgesamt zu einer deutlichen Komfortsteigerung beim Tragen der erfindungsgemäßen Innensohlen.

Der erfindungsgemäße Werkstoff aus PCM-haltigem Polyurethan-Gel kann auch das Klimaverhalten von Fahrradsitzen, Stuhlkissen, Wagensitzen, Rollstuhlsitzen oder Matratzen verbessern, um nur einige Beispiele zu nennen.

## Patentansprüche

1. Werkstoff aus einem Polyurethan-Gel, bei dem das Produkt der Funktionalitäten der Polyurethan-bildenden Komponenten wenigstens 5,2 beträgt, mit darin durch Emulgieren oder Dispergieren fein verteilten Materialien, **dadurch gekennzeichnet, dass** die fein verteilten Materialien "Phase-Change-Materialien", deren Schmelzpunkte oder Schmelzbereiche zwischen 20°C und 45 °C liegen, nämlich Paraffine sind, und der Werkstoff ein temperaturausgleichendes Verhalten zeigt.

2. Werkstoff nach Anspruch 1, **dadurch gekennzeichnet, dass** das Produkt der Funktionalitäten der Polyurethan-bildenden Komponenten mindestens 6,5, insbesondere mindestens 7,5 beträgt.

3. Werkstoff nach Anspruch 1 oder 2, **dadurch gekennzeichnet, dass** die Phase-Change-Materialien Schmelzpunkte oder Schmelzbereiche zwischen 34 °C und 39 °C aufweisen.

4. Werkstoff nach einem der Ansprüche 1 bis 3, **dadurch gekennzeichnet, dass** die Phase-Change-Materialien in einem Gewichtsanteil von bis zu 60 Gew.-%, vorzugsweise bis zu 40 Gew.-% bezogen auf das Gesamtgewicht in dem Werkstoff enthalten sind.

5. Werkstoff nach einem der Ansprüche 1 bis 4, **dadurch gekennzeichnet, dass** zusätzlich weitere Füllstoffe, insbesondere elastische Mikrohohlkugeln, vorzugsweise solche aus polymerem Material, enthalten sind.

6. Verfahren zur Herstellung eines Werkstoffs nach einem der Ansprüche 1 bis 5, **dadurch gekennzeichnet, dass** das Phase-Change-Material in wenigstens einer flüssigen PU-Komponente emulgiert oder dispergiert wird und die PU-Komponenten danach zu dem Polyurethan-Gel umgesetzt werden.

7. Verfahren nach Anspruch 6, **dadurch gekennzeichnet, dass** die Polyolkomponente zur Herstellung des Gels aus einem oder mehreren Polyolen mit einem Molekulargewicht zwischen 1000 und 12000 und einer OH-Zahl zwischen 20 und 112 besteht, wobei das Produkt der Funktionalitäten der polyurethanbildenden Komponenten mindestens 5,2 beträgt und die Isocyanat-Kennzahl zwischen 15 und 60 liegt.

8. Verfahren nach Anspruch 6 oder 7, **dadurch gekennzeichnet, dass** man als Isocyanate zur Gelherstellung solche der Formel Q(NCO) einsetzt, wobei n für 2 bis 4 steht und Q einen aliphatischen Kohlenwasserstoffrest mit 8 bis 18 C-Atomen, einen cyclophatischen Kohlenwasserstoffrest mit 4 bis 15 C-Atomen, einen aromatischen Kohlenwasserstoffrest mit 6 bis 15 C-Atomen oder einen araliphatischen Kohlenwasserstoffrest mit 8 bis 15 C-Atomen repräsentiert.

9. Verfahren nach Anspruch 8, **dadurch gekennzeichnet, dass** die Isocyanate in reiner Form oder in modifizierter Form, insbesondere urethanisiert, allophanatisiert oder biuretisiert, eingesetzt werden.

10. Verfahren nach einem der Ansprüche 6 bis 9, **dadurch gekennzeichnet, dass** das Phase-Change-Material in flüssigem Aggregatzustand eingesetzt wird.

11. Verfahren nach Anspruch 10, **dadurch gekennzeichnet, dass** das Phase-Change-Material unter Bildung einer flüssig/flüssig-Emulsion in die Polyolkomponente eingearbeitet wird.

12. Verfahren nach Anspruch 11, **dadurch gekennzeichnet, dass** ein Emulsionsstabilisator zugesetzt wird.

13. Verwendung des Werkstoffs nach einem der Ansprüche 1 bis 6 oder des Verfahrensprodukt nach einem der Ansprüche 6 bis 12 für die Herstellung von Schuhinnensohlen, Schuhauskleidungen, Matratzen, Sitzauflagen, kompletten Sitzkissen.

14. Schuhinnensohlen, **dadurch gekennzeichnet, dass** sie wenigstens bereichsweise aus einem Werkstoff nach einem der Ansprüche 1 bis 6 oder einem Verfahrensprodukt nach einem der Ansprüche 6 bis 12 besteht und vorzugsweise eine textile Abdeckung besitzt.

## Claims

1. A material of a polyurethane gel, in which the product of the functionalities of the polyurethane-forming components is at least 5.2, with materials finely distributed therein by emulsifying or dispersing, **characterized in that** the finely distributed materials are "phase change materials", the melting points or melting ranges of which lie between 20 °C and 45 °C, namely paraffins, and the material shows a temperature-equalizing behaviour.

2. The material according to Claim 1, **characterized in that** the product of the functionalities of the polyurethane-forming components is at least 6.5, in particular at least 7.5.

3. The material according to Claim 1 or 2, **characterized in that** the phase change materials have melting points or melting ranges between 34°C and 39°C.

4. The material according to any of Claims 1 to 3, **characterized in that** the phase change materials are contained in the material in a weight proportion of up to 60 % by weight, preferably up to 40 % by weight in relation to the total weight.

5. The material according to any of Claims 1 to 4, **characterized in that** in addition further fillers, in particular elastic micro hollow balls, preferably those of polymeric material, are included.

6. A method for the production of a material according to any of Claims 1 to 5, **characterized in that** the phase change material is emulsified or dispersed in at least one liquid PU component and the PU components are thereafter converted to the polyurethane gel.

7. The method according to Claim 6, **characterized in that** the polyol component for the production of the gel consists of one or more polyols with a molecular weight between 1000 and 12000 and an OH number between 20 and 112, in which the product of the functionalities of the polyurethane-forming components is at least 5.2 and the isocyanate characteristic factor lies between 15 and 60.

8. The method according to Claim 6 or 7, **characterized in that** as isocyantes to produce the gel, those of the formula Q(NCO) are used, in which n stands for 2 to 4, and Q represents an aliphatic hydrocarbon with 8 to 10 C atoms, a cyclophatic hydrocarbon radical with 4 to 15 C atoms, an aromatic hydrocarbon radical with 6 to 15 C atoms or an araliphatic hydrocarbon radical with 8 to 15 C atoms.

9. The method according to Claim 8, **characterized in that** the isocyanates are used in pure form or in modified form, in particular urethanised, allophanatised or biuretised.

10. The method according to any of Claims 6 to 9, **characterized in that** the phase change material is used in a liquid aggregate state.

11. The method according to Claim 10, **characterized in that** the phase change material is worked into the polyol component with the formation of a liquid/liquid emulsion.

12. The method according to Claim 11, **characterized in that** an emulsion stabilizer is added.

13. The use of the material according to any of Claims 1 to 6 or of the method product according to any of Claims 6 to 12 for the production of shoe insoles, shoe linings, mattresses, seat surfaces, complete seat pads.

14. Shoe insoles, **characterized in that** they consist at least in parts of a material according to any of Claims 1 to 6 or a method product according to any of Claims 6 to 12 and preferably have a textile covering.

## Revendications

1. Matériau fait d'un gel de polyuréthane, pour lequel le produit des fonctionnalités des composants formant le polyuréthane est d'au moins 5,2, ayant en son sein des matériaux finement répartis par émulsification ou mise en dispersion, **caractérisé en ce que** les matériaux finement répartis dits « matériaux Phase-Change », dont les points de fusion ou les domaines de fusion se situent entre 20 °C et 45 °C, sont notamment des paraffines et **en ce que** le matériau manifeste un comportement équilibrant la température.

2. Matériau selon la revendication 1, **caractérisé en ce que** le produit des fonctionnalités des composants formant le polyuréthanne est d'au moins 6,5, en particulier, de préférence, d'au moins 7,5.

3. Matériau selon la revendication 1 ou 2, **caractérisé en ce que** les matériaux Phase-Change présentent des points de fusion ou des domaines de fusion compris entre 34 °C et 39 °C.

4. Matériau selon l'une quelconque des revendications 1 à 3, **caractérisé en ce que** les matériaux Phase-Change sont contenus dans une proportion pondérale allant jusqu'à 60 % en poids, de préférence, jusqu'à 40 % en poids, par rapport au poids total dans le matériau.

5. Matériau selon l'une quelconque des revendications 1 à 4, **caractérisé en ce que** sont contenus en outre des charges supplémentaires, en particulier des micro billes creuses élastiques, de préférence, celles faites d'un matériau polymère.

6. Procédé en vue de la fabrication d'un matériau selon l'une quelconque des revendications 1 à 5, **caractérisé en ce que** le matériau Phase-Change est mis sous forme d'émulsion ou de dispersion dans au moins un composant de PU fluide et **en ce que** les composants de PU fluides sont ensuite convertis pour former le gel de polyuréthanne.

7. Procédé selon la revendication 6, **caractérisé en ce que** le composant de polyol en vue de la fabrication du gel se compose d'un ou de plusieurs polyols ayant un poids moléculaire compris entre 1000 et 12000 et un indice hydroxyle compris entre 20 et 112, le produit des fonctionnalités des composants formant le polyuréthanne étant d'au moins 5,2 et l'indice caractéristique isocyanate se situant entre 15 et 60.

8. Procédé selon la revendication 6 ou 7, **caractérisé en ce que** l'on utilise, en tant qu'isocyanates, en vue de la fabrication du gel, des isocyanates de la formule Q(NCO), n désignant un nombre de 2 à 4 et Q représentant un radical hydrocarboné aliphatique ayant de 8 à 18 atomes de C, un radical hydrocarboné cycloaliphatique ayant de 4 à 15 atomes de C, un radical hydrocarboné aromatique ayant de 6 à 15 atomes de C ou un radical hydrocarboné araliphatique ayant de 8 à 15 atomes de C.

9. Procédé selon la revendication 8, **caractérisé en ce que** l'on utilise les isocyanates sous forme pure ou sous forme modifiée, en particulier uréthanisée, allophanatisée ou biurétisée.

10. Procédé selon l'une quelconque des revendications 6 à 9, **caractérisé en ce que** le matériau Phase-Change est utilisé à l'état d'agrégat fluide.

11. Procédé selon la revendication 10, **caractérisé en ce que** le matériau Phase-Change est incorporé dans les composants de polyol avec formation d'une émulsion fluide-fluide.

12. Procédé selon la revendication 11, **caractérisé en ce que** l'on ajoute un agent de stabilisation d'émulsions.

13. Utilisation du matériau selon l'une quelconque des revendications 1 à 6 ou du produit du procédé selon l'une quelconque des revendications 6 à 12, en vue de la fabrication de semelles internes de chaussures, de garnitures de chaussures, de matelas, de rembourrages de sièges, de coussins de siège complets.

14. Semelles internes de chaussures, **caractérisées en ce qu'**elles se composent, au moins par zone, d'un matériau selon l'une quelconque des revendications 1 à 6 ou d'un produit de procédé selon l'une quelconque des revendications 6 à 12, et possèdent, de préférence, un recouvrement textile.
